Europäisches Patentamt

European Patent Office

Office européen des brevets

(11) Veröffentlichungsnummer : **0 123 803**
**B1**

(12) **EUROPÄISCHE PATENTSCHRIFT**

(45) Veröffentlichungstag der Patentschrift :
29.07.87

(21) Anmeldenummer : **84101652.0**

(22) Anmeldetag : **17.02.84**

(51) Int. Cl.⁴ : **H 04 B   3/28**

(54) Schaltung zur Verbesserung des Reduktionsverhaltens.

(30) Priorität : **30.04.83 DE 3315830**

(43) Veröffentlichungstag der Anmeldung :
**07.11.84 Patentblatt 84/45**

(45) Bekanntmachung des Hinweises auf die Patenterteilung : **29.07.87 Patentblatt 87/31**

(84) Benannte Vertragsstaaten :
**DE FR NL**

(56) Entgegenhaltungen :
**DE-A- 1 765 282**
**DE-A- 2 253 861**
**GB-A- 2 053 626**
**US-A- 2 159 927**

(73) Patentinhaber : **Schaltbau Gesellschaft mbH**
**Klausenburger Strasse 6**
**D-8000 München 80 (DE)**

(72) Erfinder : **Junck, Rainer, Dipl.-Ing.**
**Am Lilienberg 4**
**D-8000 München 80 (DE)**

(74) Vertreter : **Jakob, Peter H. et al**
**Patentanwälte A.Grünecker, H. Kinkeldey W.**
**Stockmair, K. Schumann P.H. Jakob, G.Bezold Maxi-**
**milianstrasse 58**
**D-8000 München 22 (DE)**

## Beschreibung

Die Erfindung bezieht sich auf eine Schaltung zur Verbesserung des Reduktionsverhaltens im hörbaren Frequenzbereich von Anlagen zum aktiven Reduktionsschutz mit einem als Leistungsverstärker dienenden Operationsverstärker, der die Primärwicklung eines als Koppelglied dienenden Transformators speist, über dessen eine als Kontrollwicklung dienende Sekundärwicklung die Pilotader geführt ist, von der das hinter dem Koppelglied verbleibende Störsignal abgegriffen wird.

Das Prinzip des aktiven Reduktionsschutzes geht aus der DE-C-16 90 370 hervor. Danach werden die durch Fremdfelder in Fernmeldeleitungen oder -kabeln induzierte Störsignale einer Pilotader entnommen, in einem Leistungsverstärker verstärkt und über einen Transformator als Koppelglied in jede betroffene Ader eingekoppelt, wobei der Ausgang des Leistungsverstärkers an die Primärwicklung des Transformators gelegt ist und jede Ader über eine Sekundärwicklung des Transformators geführt ist. Dieses Grundmodell ist wesentlich verbessert worden. So ist es aus der DE-A-29 26 092 bekannt, Phasenverschiebungen in der Zuleitung zwischen Leistungsverstärker und Koppelglied durch besondere Formen der Rückkopplung zu begegnen. Aus der deutschen Patentanmeldung P 32 45 863.0 ist zu entnehmen, wie gelegentlich auftretende Störsignale mit sehr tiefen Frequenzen von nur wenigen Hz, die den Koppeltransformator in die Sättigung bringen könnten, mit Hilfe eines invertierenden Tiefpasses und eines Summierverstärkers vor dem Eintritt in den Leistungsverstärker kompensiert werden können. Aus den europäischen Patentanmeldungen EP-A-118 799 und EP-A-123 804 sind Maßnahmen bekannt, die sowohl das Auskompensieren der sehr tiefen Frequenzen als auch die Beibehaltung des Vorteils der Rückkopplung ermöglichen. Dies geschieht zum Beispiel nach EP-A-123 804 dadurch, daß das um die sehr tiefen Frequenzen bereinigte Störsignal hinter dem Summierverstärker nicht nur dem Leistungsverstärker, sondern auch einem Hilfsverstärker zugeführt wird, dessen Ausgang ebenfalls auf den Eingang des Leistungsverstärkers gelegt ist und diesem das Störsignal in einer verminderten, dem in der Schaltung erzielten Reduktionsgrad entsprechenden Höhe zuführt.

Die meisten dieser Schaltungen zum aktiven Reduktionsschutz haben jedoch den Nachteil, daß sie eine Frequenz im Reduktionsmaximum aufweisen, während der erzielbare Reduktionsgrad zu höheren, besonders aber zu tieferen Frequenzen hin mit dem Abstand zur Optimalfrequenz schnell abnimmt. So ist es zum Beispiel bei einer Schaltung nach der europäischen Patentanmeldung EP-A-123 804 möglich, das Reduktionsmaximum auf 19 Hz einzustellen und dabei im Bereich von 16 2/3 Hz bis 800 Hz einen ausreichenden Reduktionsgrad zu erzielen. Damit wird zwar der Frequenzbereich der häufigsten und wesentlichsten Störfelder überdeckt, jedoch treten auch Frequenzen im Hörbereich von etwa 300 Hz bis zu etwa 3 kHz auf, die mit dieser Schaltung nicht erfaßt werden können.

Der Erfindung liegt die Aufgabe zugrunde, eine Schaltung anzugeben, die es bei Beibehalt und gegebenenfalls sogar Verbesserung des bisherigen Reduktionsverhaltens ermöglicht, die im Störspektrum auftretenden Frequenzen des Hörbereichs ebenfalls so zu erfassen, daß sie nicht über den Verstärker und das Koppelglied wieder in die zu schützenden Adern eingekoppelt werden.

Dies geschieht erfindungsgemäß dadurch, daß das hinter dem Koppelglied abgegriffene, reduzierte Störsignal sowohl dem Eingang eines Summierverstärkers als auch einem invertierenden Tiefpaß zugeführt wird, dessen Grenzfrequenz eine Optimierung im Hörbereich erlaubt und dessen Ausgang ebenfalls dem Eingang des Summierverstärkers zugeführt wird, während der Ausgang des Summierverstärkers am Eingang des Leistungsverstärkers liegt.

Die erfindungsgemäße Schaltung erlaubt es, neben den häufigsten und stärksten Störfeldern, die insbesondere aus den Versorgungsnetzen von Großverbrauchern kommen, auch Störfrequenzen des Hörbereichs weitgehend von den Fernmeldeadern fernzuhalten, ohne den Reduktionsgrad bei den üblichen Störfeldern zu beeinträchtigen.

In Weiterbildung der Erfindung kann vor den Tiefpaß ein Vorverstärker vorgesehen werden.

Die erfindungsgemäße Schaltung ist auch dann anwendbar, wenn der magnetisch wirksame Teil des Koppelglieds aus dem Mantel oder der Bewehrung des geschützten Kabels besteht, jedoch ist es dann vorteilhaft, zwischen Vorverstärker und Tiefpaß zur besseren Anpassung an den jeweiligen Kabeltyp einen Phasenschieber vorzusehen.

Von besonderem Vorteil ist die Anwendung der erfindungsgemäßen Schaltung in Anlagen zum aktiven Reduktionsschutz für einen vorgegebenen Bereich von störenden Frequenzen mit Mitteln zur Kompensation sehr tiefer, außerhalb des vorgesehenen Bereichs liegender Frequenzen, die verstärkt und auf den Koppeltransformator gegeben, diesen der Sättigung nahe bringen können, bei der das um diese Frequenzen bereinigte Störsignal dem Leistungsverstärker und zusätzlich einem Hilfsverstärker zugeführt wird, dessen Ausgang ebenfalls auf den Eingang des Leistungsverstärkers gelegt ist und diesem das Störsignal in einer verminderten, dem in der Schaltung erzielten Reduktionsgrad entsprechenden Höhe zuführt. Eine solche Anlage ist Gegenstand der europäischen Patentanmeldung EP-A-123 804.

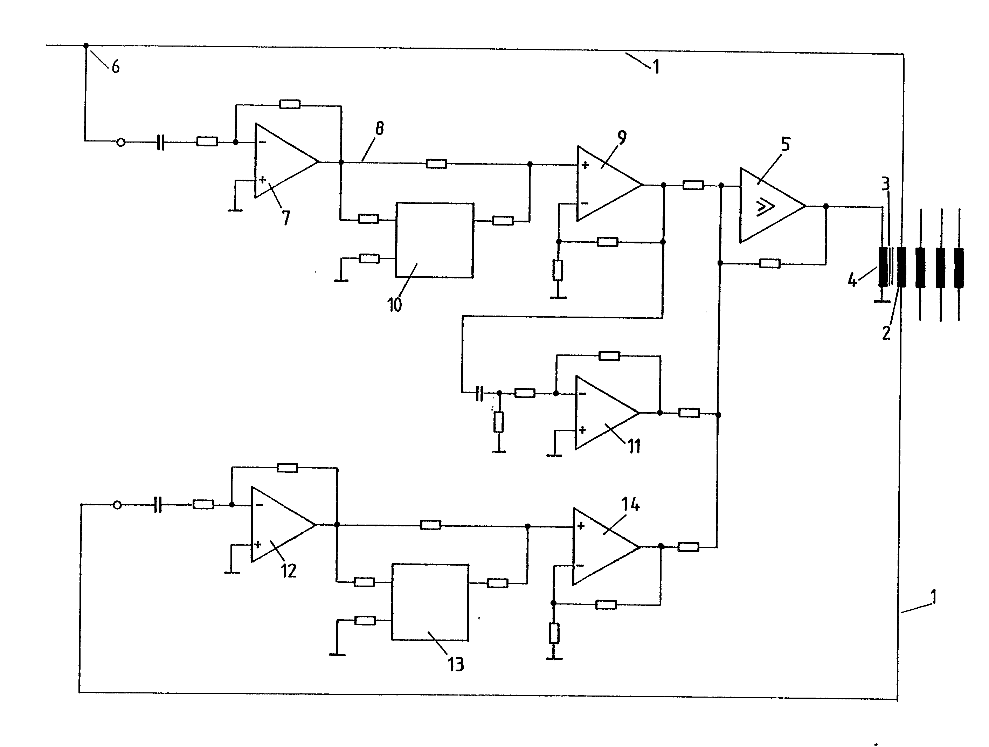

Die Figur zeigt in zum Teil schematischer Darstellung ein Ausführungsbeispiel der erfindungsgemäßen Schaltung, angewendet auf eine Anlage, wie sie im vorhergehenden Absatz beschrieben ist.

Mit 1 ist die Pilotader bezeichnet, die über eine als Kontrollwicklung dienende Sekundärwicklung 2 des Koppeltransformators 3 geführt ist, dessen Primärwicklung 4 aus dem als Leistungsverstärker dienender Operationsverstärker 5 gespeist wird. Vor dem Koppeltransformator 3 wird der Pilotader 1 bei 6 das austretende Störsignal entnommen und zunächst einem Vorverstärker 7 zugeführt. Hinter dessen Ausgang wird das Störsignal über die Leitung 8 dem einen Eingang des Summierverstärkers 9 als auch über einen invertierenden Tiefpaß 10 dem zweiten Eingang des Summierverstärkers 9 zugeführt. Der Tiefpaß 10 hat z. B. eine Grenzfrequenz von 3 Hz und dient dazu, nur sehr niedrige Störfrequenzen, die eine Sättigung des Koppeltransformators 3 verursachen könnten, durchzulassen und umzukehren. Mithin stehen am Eingang des Summierverstärkers 9 über die Leitung 8 das Störsignal mit den sehr niedrigen Frequenzen und aus dem Tiefpaß 10 die invertierten tiefen Frequenzen an, die in dem Summierverstärker 9 auskompensiert werden, so daß am Ausgang des Summierverstärkers 9 das um die sehr tiefen Frequenzen bereinigte Störsignal ansteht. Das bereinigte Störsignal wird einmal als erste Komponente dem Eingang des Leistungsverstärkers 5 und ebenso dem Eingang des Hilfsverstärkers 11 zugeführt. Der Hilfsverstärker 11 ist so beschaffen, daß an seinem Ausgang ein vermindertes Störsignal auftritt, das dem Signal entspricht, das man hinter dem Koppeltransformator abgreifen könnte. Es entspricht also in seiner Höhe dem in der Schaltung erzielbaren Reduktionsgrad und wird ebenfalls dem Eingang des Leistungsverstärkers 5 als zweite Komponente zugeführt.

Der bis dahin beschriebene Teil der dargestellten Schaltung kann z. B. auf ein Reduktionsmaximum von 19 Hz eingestellt werden. Damit wird ein vertretbarer Reduktionsgrad in dem Bereich von etwa 16 2/3 bis 800 Hz erzielt.

Um entsprechend der gestellten Aufgabe nun auch die Störfrequenzen im höheren Frequenzbereich zu erfassen, wird nun erfindungsgemäß an der Pilotader 1 hinter dem Koppeltransformator 3 das dort anstehende Störsignal abgegriffen und entsprechend den Bauelementen 7 bis 10 einer Kombination von Vorverstärker 12, invertierendem Tiefpaß 13 und Summierverstärker 14 zugeführt, dessen Ausgang eine dritte Komponente für den Eingang des Leistungsverstärkers liefert. Die Grenzfrequenz des Tiefpaßes 13 erlaubt es, Störungen aus dem höheren Frequenzbereich zu erfassen. Sie liegt damit erheblich höher als die des Tiefpaßes 10. Bemißt man sie auf z. B. 36 Hz, so kann man damit befriedigend Frequenzen im Bereich von etwa 100 Hz bis etwa 3 kHz erfassen. Dies hat den zusätzlichen Vorteil, daß der eingangs beschriebene Schaltungsteil auf 16 2/3 Hz optimiert werden kann, obgleich dessen obere Grenze des hinreichenden Reduktionsgrades damit auf etwa 100 Hz gesenkt wird. Die dargestellte Schaltung erlaubt somit eine optimale Reduktion im Bereich von 16 2/3 Hz bis weit in den hörbaren Bereich hinein.

**Patentansprüche**

1. Schaltung zur Verbesserung des Reduktionsverhaltens im hörbaren Frequenzbereich von Anlagen zum aktiven Reduktionsschutz mit einem als Leistungsverstärker dienenden Operationsverstärker (5), der die Primärwicklung (4) eines als Koppelglied dienenden Transformators (3) speist, über dessen eine als Kontrollwicklung dienende Sekundärwicklung (2) die Pilotader (1) geführt ist, von der das hinter dem Koppelglied verbleibende Störsignal abgegriffen wird, dadurch gekennzeichnet, daß das reduzierte Störsignal sowohl dem Eingang eines Summierverstärkers (14) als auch einem invertierenden Tiefpaß (13) zugeführt wird, dessen Grenzfrequenz eine Optimierung im Hörbereich erlaubt und dessen Ausgang ebenfalls dem Eingang des Summierverstärkers (14) zugeführt wird, während der Ausgang des Summierverstärkers am Eingang des Leistungsverstärkers (5) liegt.

2. Schaltung nach Anspruch 1, dadurch gekennzeichnet, daß vor dem Tiefpaß ein Vorverstärker (12) für das verbleibende Störsignal aus der Pilotader vorgesehen ist.

3. Schaltung nach Anspruch 2, dadurch gekennzeichnet, daß vor dem Tiefpaß ein Phasenschieber vorgesehen ist.

4. Schaltung nach Anspruch 1 oder einem der folgenden, gekennzeichnet durch ihre Anwendung in Anlagen zum aktiven Reduktionsschutz für einen vorgegebenen Bereich von störenden Frequenzen mit Mitteln zur Kompensation sehr tiefer, außerhalb des vorgesehenen Bereichs liegender Frequenzen, die verstärkt und auf den Koppeltransformator gegeben, diesen der Sättigung nahe bringen können, bei der das um diese Frequenzen bereinigte Störsignal dem Leistungsverstärker und zusätzlich einem Hilfsverstärker (11) zugeführt wird, dessen Ausgang ebenfalls auf den Eingang des Leistungsverstärkers (5) gelegt ist und diesem das Störsignal in einer verminderten, der in der Schaltung erzielten Reduktionsgrad entsprechenden Höhe zuführt.

**Claims**

1. Circuit for improving the reduction characteristic in the audible range of frequencies of systems for active reduction protection comprising an operational amplifier (5) which is used as power amplifier and which feeds the primary winding (4) of a transformer (3) which is used as coupling section and via one secondary winding (2) of which, which is used as control winding, the pilot wire (1) is passed from which the interference signal remaining after the coupling section is picked up, characterized in that the reduced interference signal is fed both to the input of a summing amplifier (14) and to an inverting low-pass filter (13) the cut-off frequency of which allows optimization in the audible range and the output of which is also fed to the input of the summing amplifier (14) whilst the output of the summing amplifier is connected to the input of the power amplifier (5).

2. Circuit according to Claim 1, characterized in that a preamplifier (12) for the remaining interference signal from the pilot wire is provided in front of the low-pass filter.

3. Circuit according to Claim 2, characterized in that a phase-shifting circuit is provided in front of the low-pass filter.

4. Circuit according to Claim 1 or one of the subsequent claims, characterized by its application in systems for active reduction protection for a predetermined range of interfering frequencies comprising means for compensating very low frequencies located outside the intended range which, amplified and applied to the coupling transformer, can bring this transformer close to saturation, in which the interference signal, from which these frequencies have been removed, is supplied to the power amplifier and additionally to an auxiliary amplifier (11) the output of which is also applied to the input of the power amplifier (5) and supplies the latter with the interference signal at a reduced level corresponding to the degree of reduction achieved in the circuit.

**Revendications**

1. Circuit pour l'amélioration des caractéristiques de la réduction des interférences dans la zone des fréquences audibles d'installations pour la protection de réduction active, comportant un amplificateur opérationnel (5) servant d'amplificateur de puissance, qui alimente l'enroulement primaire (4) d'un transformateur (3) servant d'organe de couplage, le fil conducteur pilote (1) passant par un enroulement secondaire (2) du transformateur, servant d'enroulement de contrôle, le signal perturbateur restant en arrière de l'organe de couplage étant pris à partir du fil conducteur pilote, circuit caractérisé en ce que le signal perturbateur réduit est amené à l'entrée d'un amplificateur additif (14) ainsi qu'à un filtre passe-bas (13) inversant, dont la fréquence-limite permet une optimisation dans la zone audible et dont la sortie est amenée également à l'entrée de l'amplificateur additif (14), tandis que la sortie de l'amplificateur additif se trouve à l'entrée de l'amplificateur de puissance (5).

2. Circuit selon la revendication 1, caractérisé en ce que, en avant du filtre passe-bas, est prévu un pré-amplificateur (12) pour le signal perturbateur restant provenant du fil conducteur pilote.

3. Circuit selon la revendication 2, caractérisé en ce que, en avant du filtre passe-bas, est prévu un décaleur de phase.

4. Circuit selon la revendication 1 ou l'une des suivantes, caractérisé par son application dans des installations servant à la protection de réduction active pour une zone prédéterminée de fréquences perturbatrices, comportant des moyens pour compenser des fréquences très basses se situant en-dehors de la zone prévue et qui, amplifiées et arrivant au transformateur de couplage, peuvent amener celui-ci au voisinage de la saturation, circuit selon lequel le signal perturbateur corrigé de ces fréquences est amené à l'amplificateur de puissance et en plus à un amplificateur auxiliaire (11), dont la sortie est placée également à l'entrée de l'amplificateur de puissance (5) et amène à celui-ci le signal perturbateur à un niveau amoindri, correspondant au taux de réduction obtenu dans le circuit.

1